**Europäisches Patentamt**

**European Patent Office**

**Office européen des brevets**

(19)

(11) Numéro de publication : **0 397 559 B1**

# (12) FASCICULE DE BREVET EUROPEEN

(45) Date de publication du fascicule du brevet :
**02.02.94 Bulletin 94/05**

(51) Int. Cl.⁵ : **H03K 3/78, H04L 1/24,**
**H04J 3/12**

(21) Numéro de dépôt : **90401221.8**

(22) Date de dépôt : **09.05.90**

(54) **Générateur de données numériques.**

(30) Priorité : **10.05.89 FR 8906130**

(43) Date de publication de la demande :
**14.11.90 Bulletin 90/46**

(45) Mention de la délivrance du brevet :
**02.02.94 Bulletin 94/05**

(84) Etats contractants désignés :
**BE CH DE ES GB IT LI NL SE**

(56) Documents cités :
**DE-B- 2 721 764**

(73) Titulaire : **SCHLUMBERGER INDUSTRIES**
**50, avenue Jean Jaurès**
**F-92120 Montrouge (FR)**

(72) Inventeur : **Richardson, Mark William**
**6, Allée des Millepertuis**
**F-42230 Saint-Victor sur Loire (FR)**

(74) Mandataire : **Joly, Jean-Jacques et al**
**Cabinet Beau de Loménie 158, rue de**
**l'Université**
**F-75340 Paris Cédex 07 (FR)**

## Description

La présente invention concerne un générateur de données numériques, et elle porte plus particulièrement sur un générateur qui produit des données série sous un format conforme à une norme de télécommunication.

On utilise de nombreuses normes de télécommunication, comme par exemple les normes V.24, V.35, G704 et X50 du CCITT. Toutes ces normes visent à assurer la synchronisation d'un train de données série, de façon à permettre d'identifier correctement des mots de données qui sont constitués par un nombre prédéterminé de bits de données individuels. Le mot de données numériques à transmettre (qu'on appelle dans la technique une séquence ou une configuration binaire) est synchronisé bit par bit avec une horloge définissant la cadence de transmission de données, pour former un train de données. Dans une norme de transmission caractéristique, la séquence de données est environnée par des bits de synchronisation, que le canal de télécommunication utilise pour assurer la réception et l'acheminement corrects des données. Dans une norme simple, le train de données comporte un préfixe consistant en un code prédéterminé (les bits de "départ") et il est suivi par un second code prédéterminé (les bits "d'arrêt"). Les données peuvent être reçues à la suite de la détection des bits de départ, tandis que la détection des bits d'arrêt garantit que la synchronisation n'a pas été perdue et que la séquence a été reçue de façon valide. Le train de données constitué par la séquence et les bits de synchronisation est ce qu'on appelle une trame. Dans de nombreuses normes, les trames sont elles-mêmes groupées en multitrames, contenant chacune un nombre de trames prédéterminé, chaque multitrame comportant ses propres bits de synchronisation. Ceci améliore la synchronisation et permet de multiplexer dans une seule multitrame des données provenant d'un certain nombre de sources différentes; à titre d'exemple, une séquence provenant de chaque source peut être transmise dans la même position de trame dans chaque multitrame. Une norme spécifie de façon caractéristique le nombre de bits de séquence, le nombre et la position de bits de synchronisation (par exemple le nombre de bits de départ et de bits d'arrêt), le nombre de trames par multitrame et le nombre et la position des bits de synchronisation de multitrame. La norme spécifie également les caractéristiques de la forme d'onde qui constitue le train de données, par exemple des niveaux de tension pour des bits à l'état haut et à l'état bas, et des temps de montée de la forme d'onde aux transitions entre bits.

Il est nécessaire de tester des réseaux de télécommunication pour vérifier que la communication s'effectue conformément à la norme choisie, et que cette norme permet une transmission avec un taux d'erreur raisonnablement faible. Pour effectuer un tel test, on utilise un générateur de données pour injecter des données dans le réseau. A l'extrémité réceptrice, on peut effectuer des mesures pour établir divers paramètres concernant le réseau, et on pourrait par exemple effectuer des tests pour répondre aux questions suivantes :

i) est-ce que les formes d'onde qui apparaissent à l'extrémité réceptrice sont acceptables, d'après la norme ?

ii) est-ce qu'un équipement de réception fonctionnant conformément à la norme peut être correctement synchronisé ?, et

iii) est-ce que des données peuvent être reçues de façon fiable ?

Un test du type (i) ci-dessus pourrait être un test relativement simple, effectué avec un instrument de mesure, par exemple un oscilloscope. Un certain équipement de réception (comprenant au moins les circuits de synchronisation) sera nécessaire pour un test du type (ii) ci-dessus, tandis qu'un récepteur complet avec des possibilités de décodage et de comparaison/enregistrement de données sera nécessaire pour un test du type (iii).

Tous les types de test ont en commun la nécessité d'un générateur de données, capable de produire un train de données représentatif, conforme à la norme qui est utilisée. Des générateurs de données classiques comprennent un générateur de séquences comportant une entrée d'horloge de façon qu'un bit de données soit émis à chaque transition d'horloge, par exemple, et un certain matériel de commande pour extraire une séquence à l'instant exigé et pour ajouter des bits de synchronisation dans le train d'impulsions. Des générateurs de séquences sont bien connus dans la technique et ils peuvent par exemple produire des données de séquence conformément à un algorithme ou une fonction prédéterminé (par exemple une fonction polynomiale), de façon à permettre de déterminer si la réception est exempte d'erreur, ou un signal aléatoire pour permettre d'établir des caractéristiques statistiques concernant un réseau de transmission.

Il est souhaitable qu'un générateur de données soit capable de fonctionner conformément à plus d'une norme, du fait qu'un tel équipement est de façon caractéristique un équipement portable prévu pour des tests en exploitation, et qu'il existe de nombreuses normes de réseau différentes à tester. Lorsqu'il existe des différences de cadence de données entre des réseaux à tester, un simple changement de rythme d'horloge peut suffire, mais lorsque des normes différentes interviennent, un matériel de commande différent sera nécessaire. Les générateurs de données comportent de façon caractéristique des commutateurs permettant de commuter le matériel de commande (par exemple des temporisateurs, des portes et des compteurs) de façon à commander le générateur de séquences conformément à la norme considérée, ou bien ces générateurs ont une conception modulaire permettant l'insertion de cartes qui portent un matériel de commande approprié à la norme considérée.

Un certain nombre de défauts subsistent dans des générateurs de données conçus de cette manière. On ne peut tester que des réseaux correspondant aux normes pour lesquelles un matériel de commande est disponible. Il peut être difficile d'adapter un générateur existant à une norme nouvellement spécifiée, et il y a au mieux un certain délai avant qu'un utilisateur obtienne un nouveau matériel de commande. On ne peut pas adapter aisément de tels générateurs à des tests portant sur des normes multiples, et ce type de test est impossible avec des générateurs modulaires.

Conformément à l'invention, un générateur de données comprend :

un dispositif de mémoire qui est adressé de façon incrémentielle à partir d'une valeur prédéterminée, sous la dépendance d'une horloge,

le dispositif contenant des mots de données,

chaque bit de chaque mot de données représentant un état d'un signal de commande pendant une trame,

des moyens logiques pour combiner les signaux de commande de façon à donner un signal de commande supplémentaire pour un générateur de séquences, et pour combiner en outre ces signaux avec le signal de sortie du générateur de séquences, pour donner un train de données,

l'un au moins des signaux de commande précités étant représentatif d'une longueur de trame et étant conçu de façon à recommencer l'adressage du dispositif à partir de la valeur prédéterminée.

Il est préférable que d'autres signaux parmi les signaux de commande précités soient représentatifs de la longueur de séquence, de la longueur de multitrame, de bits de synchronisation de trame et de bits de synchronisation de multitrame.

Les données de sortie sont avantageusement mémorisées dans des bascules, et il existe avantageusement des moyens prévus pour écrire dans le dispositif de mémoire pendant un intervalle d'horloge. De cette manière, on peut changer les caractéristiques des données qui sont produites, tout en maintenant un fonctionnement continu du générateur.

D'autres caractéristiques et avantages de l'invention seront mieux compris à la lecture de la description détaillée qui suit d'un mode de réalisation, uniquement à titre d'exemple, et en se référant aux dessins annexes dans lesquels :

La figure 1 représente un générateur de données conforme à l'invention.

La figure 2 représente un diagramme séquentiel de formes d'onde concernant le mode de réalisation de la figure 1;

La figure 3 représente un mode de réalisation supplémentaire de l'invention; et

Les figures 4 et 5 représentent des diagrammes séquentiels qui sont associés au mode de réalisation de la figure 3.

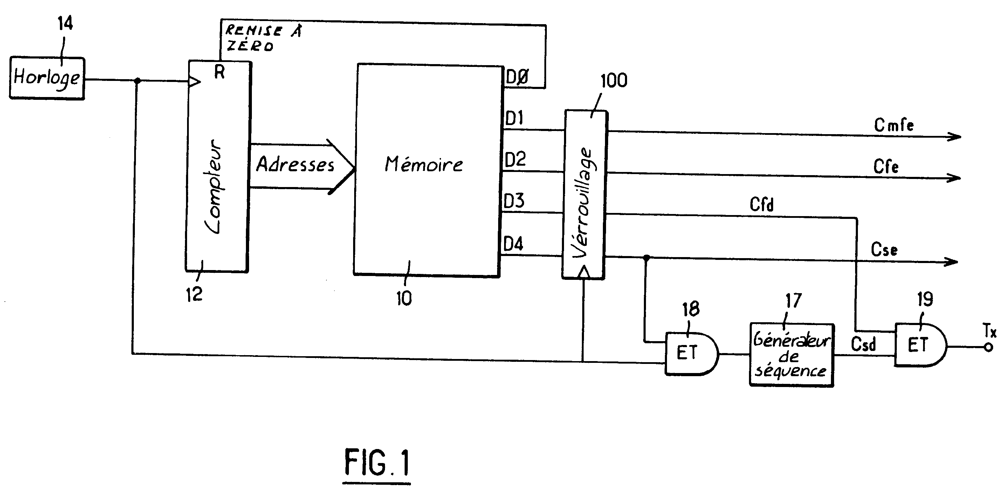

Dans un générateur de données (figure 1), un dispositif de mémoire 10 comporte des entrées d'adresse 11 et un ensemble de sorties de données (D0-D4). Les entrées d'adresse sont connectées aux sorties d'un compteur 12 dont l'entrée d'horloge est attaquée par une horloge de base 14. La mémoire 10 est ainsi adressée de façon incrémentielle sur la base de la période d'horloge, à partir d'une valeur prédéterminée qui peut être chargée dans le compteur, par exemple à partir de zéro lorsque le compteur 12 est remis à zéro. L'entrée de remise à zéro du compteur 12 est attaquée par la sortie D0 de la mémoire 10, ce qui fait que chaque fois que les données qui sont chargées dans le bit D0 de la mémoire 10, à l'adresse définie par le compteur 12, sont à l'état haut, le compteur 12 est remis à zéro et l'adressage incrémentiel de la mémoire 10 recommence à partir de zéro.

Le bit D0 de la mémoire 10 fournit un signal de commande représentatif de la longueur de trame ou de multitrame, et la mémoire 10 est programmée de façon à contenir une valeur haute à l'adresse dont la valeur représente le nombre total de cycles d'horloge de base nécessaires pour la structure de trame (ou de multitrame) désirée. Par exemple, pour une structure de multitrame occupant 16 bits, D0 serait programmé à l'état haut à l'adresse 15 (la seizième position) pour effectuer la remise à zéro du compteur toutes les 16 périodes d'horloge. Avec ce régime cyclique, d'autres bits de données de la mémoire 10 sont programmés de façon à représenter d'autres signaux de commande qu'exige la structure de trame. Les bits de données, à l'exception du bit D0, sont verrouillés dans un réseau de verrouillage 100 sous l'effet de l'horloge 14.

Le bit D1 fournit un signal d'impulsion de synchronisation de multitrame Cmfe, tandis que le bit D2 fournit un signal d'impulsion de synchronisation de trame Cfe. Des données pour la synchronisation de multitrame et de trame sont fournies dans le bit D3.

Le bit D4 fournit un signal Cse qui est placé à l'état haut pour valider un générateur de séquences 17, et chaque impulsion reçue par le générateur de séquences fournit un bit d'un mot dans la séquence, au moment

EP 0 397 559 B1

de la réception d'une impulsion d'horloge. Le générateur de séquences 17 est conçu de façon à recevoir des impulsions d'horloge par l'intermédiaire d'une porte ET 18, pour produire le signal de données de séquence Csd, lorsqu'il est validé par le signal Cse. Enfin, les signaux de données sont combinés par une porte OU 19 pour produire un signal de transmission Tx conformément à la norme de transmission exigée.

On va maintenant considérer de façon plus détaillée le fonctionnement du mode de réalisation de la figure 1 et la programmation de la mémoire.

On considérera à titre d'exemple une norme de transmission qui est spécifiée par une trame de huit bits dans laquelle le premier bit est un bit de synchronisation de trame, les six bits suivants sont réservés pour l'insertion d'une séquence et le dernier bit est prévu pour la synchronisation de multitrame, la multitrame contenant deux trames. Pour la synchronisation de trame, les bits de synchronisation sont toujours au niveau bas, tandis que pour la synchronisation de multitrame, la première trame de la multitrame a un bit de synchronisation au niveau haut et la seconde un bit au niveau bas. Pour fournir des données conformes à la norme ci-dessus, la mémoire 10 est programmée de la façon suivante :

| | | Cmfe | Cfe | Cfd | Cse |
|---|---|---|---|---|---|
| Adresse | D0 | D1 | D2 | D3 | D4 |
| 0 | 0 | 0 | 1 | 0 | 0 |
| 1 | 0 | 0 | 0 | 0 | 1 |
| 2 | 0 | 0 | 0 | 0 | 1 |
| 3 | 0 | 0 | 0 | 0 | 1 |
| 4 | 0 | 0 | 0 | 0 | 1 |
| 5 | 0 | 0 | 0 | 0 | 1 |
| 6 | 0 | 0 | 0 | 0 | 1 |
| 7 | 0 | 1 | 0 | 0 | 0 |
| 8 | 0 | 0 | 1 | 0 | 0 |
| 9 | 0 | 0 | 0 | 0 | 1 |
| 10 | 0 | 0 | 0 | 0 | 1 |
| 11 | 0 | 0 | 0 | 0 | 1 |
| 12 | 0 | 0 | 0 | 0 | 1 |
| 13 | 0 | 0 | 0 | 0 | 1 |
| 14 | 0 | 0 | 0 | 0 | 1 |
| 15 | 1 | 1 | 0 | 1 | 0 |

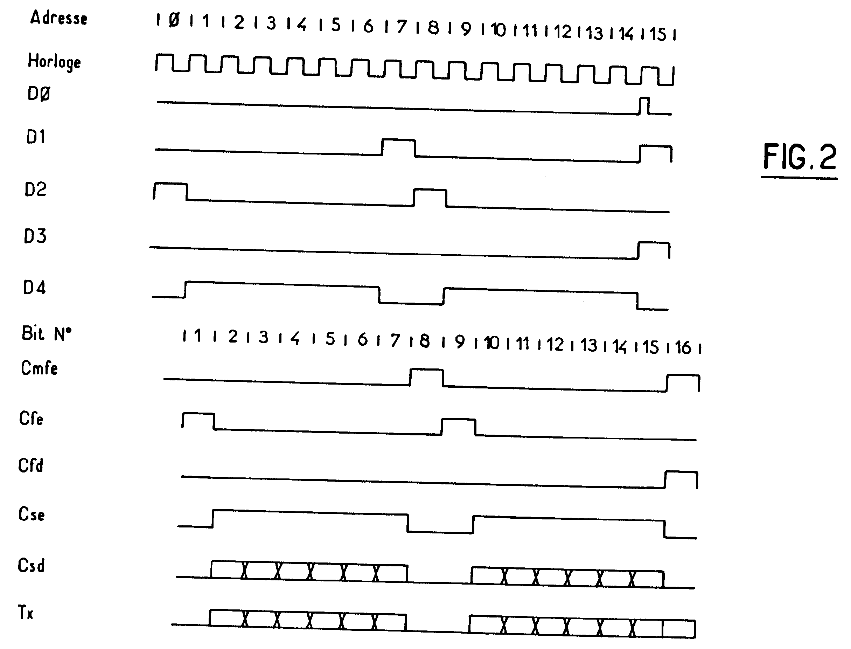

La figure 2 montre un diagramme séquentiel relatif au fonctionnement du mode de réalisation de la figure 1, avec la mémoire programmée de la manière indiquée ci-dessus. On peut voir sur ce diagramme que le Bit 1 du signal Tx qui est produit contient le bit de synchronisation de trame (0), les Bits 2 à 7 contiennent un mot de séquence inséré et le Bit 8 contient un bit de synchronisation de multitrame (0). Le Bit 9 contient le bit de synchronisation de trame (0) pour la seconde trame, les Bits 10 à 15 contiennent un mot de séquence et le Bit 16 contient un bit de synchronisation de multitrame (1). Lorsque le compteur atteint 15, la valeur haute de D0 provoque l'apparition d'une impulsion de remise à zéro, ce qui fait recommencer l'adressage de manière que le Bit 16 soit suivi de façon cyclique par le Bit 1, et ainsi de suite. On obtient donc un signal de données conforme à la norme de transmission spécifiée.

S'il est nécessaire de disposer d'un signal de données produit conformément à une norme de transmission différente, on peut reprogrammer la mémoire. Par exemple, si les bits de synchronisation de trame doivent être au niveau haut, on peut programmer la mémoire avec des bits de niveau haut en D3, aux adresses 0 et 8. Pour des structures de multitrame plus complexes, on spécifie un code de synchronisation, au lieu des bits uniques de l'exemple simple ci-dessus. On peut réaliser ceci de façon directe en programmant l'impulsion de synchronisation appropriée (Cmfe ou Cfe) de façon qu'elle soit au niveau haut sur la longueur du code, et en programmant le code lui-même dans les positions de données appropriées (Cfd). Dans l'exemple ci-dessus, si la syn-

4

chronisation de trame devait être développée d'un bit à trois bits, le Bit D2 aux positions 0, 1 et 2 serait programmé au niveau haut, et le Bit D3 serait programmé avec le code aux mêmes positions. La manière selon laquelle les autres positions doivent être reprogrammées et le passage du niveau "haut" de D0 de l'adresse 15 à l'adresse 19, apparaîtront à l'homme de l'art. On peut introduire d'autres codes, par exemple des codes d'en-tête de multitrame, dans le signal Cfd. Les signaux Cfe, Cmfe, Cse, et n'importe quels autres signaux de validation, sont fournis en tant que signaux de sortie, pour permettre la réalisation de l'interface avec un autre équipement, comme par exemple un générateur de perturbation. Ces signaux constituent des signaux d'horloge pour la commande d'un équipement capable de réagir directement à des impulsions de synchronisation et des signaux de validation de séquence.

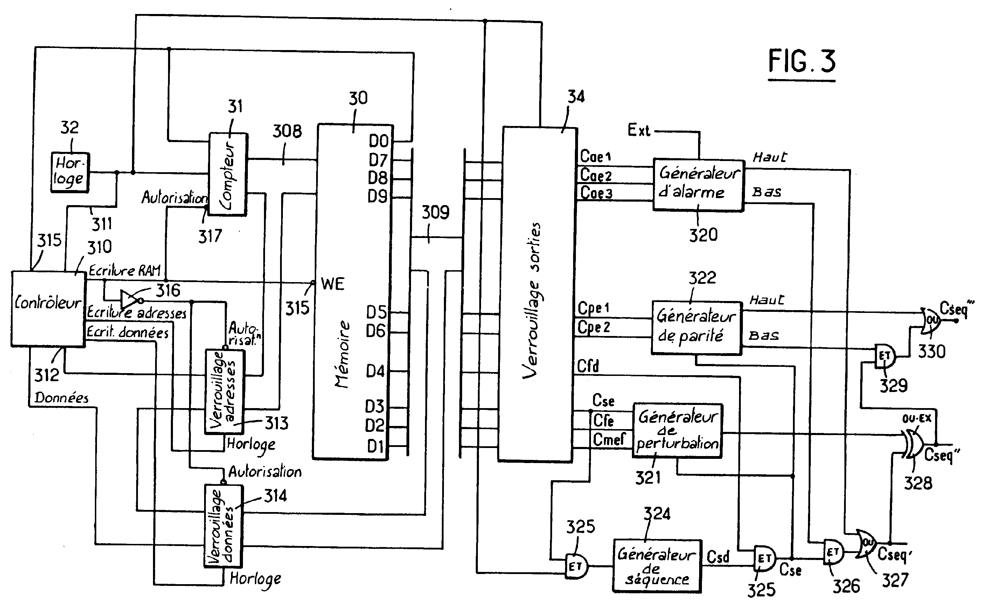

Dans un mode de réalisation supplémentaire de l'invention (figure 3), un dispositif de mémoire 30 est adressé de façon incrémentielle par un compteur 31, sous la dépendance d'une horloge 32. Le compteur 31 est remis à zéro par le bit de données D0 de la mémoire 30 pour procurer un adressage incrémentiel cyclique. Des bits de sortie D1 à D9 sont appliqués à un réseau de verrouillage 34, dont l'entrée d'horloge est attaquée par la sortie d'horloge de base 32. Le réseau de verrouillage 34 est conçu de façon à être chargé sur le front de sens positif de l'horloge 32, pour que les signaux de sortie du réseau de verrouillage soient stables pendant chaque période d'horloge. Les bits de sortie du dispositif de mémoire 30 représentent des signaux de commande qui sont des signaux de validation ou de données.

D'une manière analogue à celle décrite en relation avec le mode de réalisation de la figure 1, le signal Cse commande l'application d'impulsions d'horloge à un générateur de séquences 324, par l'intermédiaire d'une porte ET 325. Le signal de sortie Csd du générateur de séquences est combiné avec le signal de données de synchronisation de trame programmées, Cfd, de façon à fournir le signal de configuration binaire désiré Cseq.

Dans le mode de réalisation décrit ci-dessus, les signaux de sortie de bits de données qui constituent les signaux de commande portent les désignations suivantes :

D0     Remise à zéro du compteur
D1     Validation de synchronisation de multitrame     Cmfe
D2     Validation de synchronisation de trame     Cfe
D3     Données de synchronisation de trame     Cfd
D4     Validation du générateur de séquences     Cse
D5     Validation du générateur de parité     CPe1
D6     Arrêt du générateur de parité     CPe2
D7     Validation du générateur d'alarme     Cae1
D8     Commande du générateur d'alarme     Cae2
D9     Commande du générateur d'alarme     Cae3

On notera qu'avec cette structure, il est possible de produire des signaux conformes à n'importe quelle norme de télécommunication, cette possibilité comprenant, si on le désire, le forçage à certaines valeurs des bits de départ, d'arrêt et de parité.

On notera que le mode de réalisation de l'invention décrit ci-dessus est programmable conformément à n'importe quelle norme existante et à virtuellement n'importe quelle norme qu'on pourrait imaginer. En particulier, ce mode de réalisation fournit directement des signaux commandant un générateur d'alarme 320, un générateur de perturbation 321 et un générateur de parité.

Le générateur d'alarme 320 peut être commandé par ses trois signaux de commande/validation Cae1, Cae2 et Cae3 qui sont produits. Conformément à la pratique habituelle, les signaux de commande consistent en un signal de temps (Cae1), c'est-à-dire un signal qui indique la place dans la séquence à laquelle des données doivent être insérées, et en signaux de fixation au niveau haut (Cae2) et de fixation au niveau bas (Cae3), qui produisent respectivement une impulsion lorsque les données doivent être au niveau haut ou au niveau bas. De plus, le générateur d'alarme 320 réagit à un signal d'entrée externe EXT, qui détermine si les bits doivent être insérés ou non. On notera qu'en utilisant le générateur d'alarme, il est possible d'insérer des bits en n'importe quel point dans la configuration binaire, selon ce qui est exigé. On utilisera de façon caractéristique des bits insérés, ou des alarmes, pour déclencher des événements dans l'équipement de réception ou de contrôle. Des alarmes peuvent consister en un seul bit (au niveau haut ou au niveau bas) à une position désignée dans la trame, en une configuration répétitive à l'intérieur de la trame, ou en une configuration émise bit à bit à des positions désignées, sur plusieurs trames.

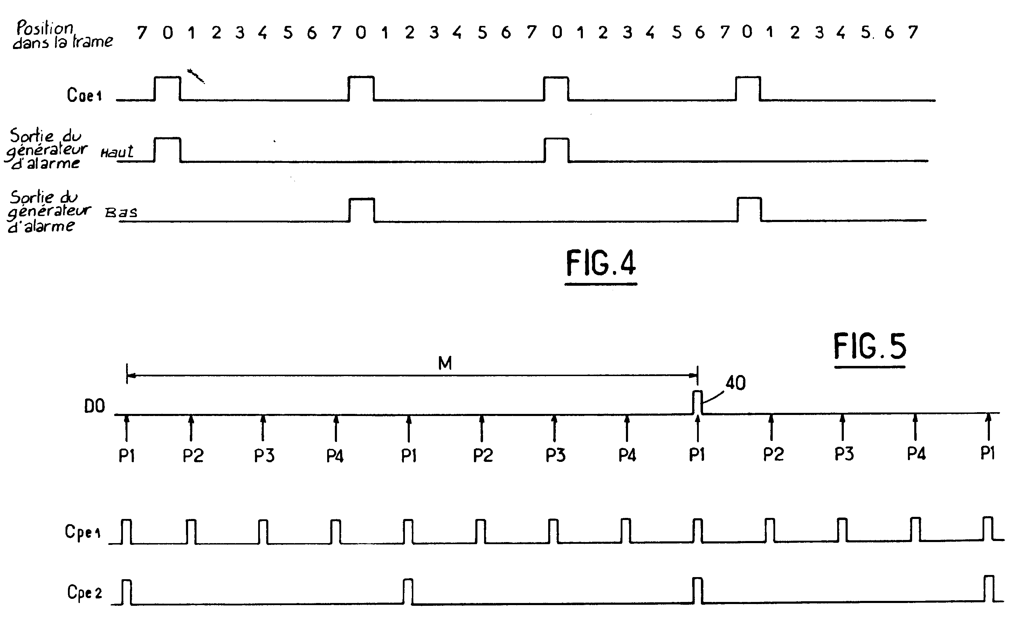

A titre d'exemple, dans une trame de huit bits dans laquelle le bit zéro est réservé dans un but d'alarme, on pourrait définir l'alarme par la séquence respective 1010. Pour insérer une telle alarme, on programmerait le bit D7 (Cae1) pour produire le signal qui est représenté sur la figure 4. Le générateur d'alarme produit un signal de sortie HAUT (bit de fixation de niveau à l'état haut) et un signal de sortie BAS (bit de fixation de niveau à l'état bas) qui sont combinés avec le signal de configuration binaire Cseq par une porte OU 327 et une porte ET 326, pour produire le signal de configuration binaire désiré (Cseq'). Une alarme pourrait consister de façon caractéristique en une séquence prédéterminée insérée un bit à la fois sur 15 multitrames. Les autres bits D8, Cae2 et D9, Cae3 sont utilisés pour produire les autres alarmes.

Le générateur de perturbation 321, qui peut avoir une configuration connue dans la technique, est utilisé pour injecter des erreurs dans le signal qui est produit, en inversant l'état d'un bit ou en maintenant un bit à l'état BAS (pour simuler une perte de signal). De façon caractéristique, un tel générateur serait capable de produire "n" erreurs consécutives tous les "m" bits, avec $1 \leqq n \leqq 250$ et $n \leqq m \leqq 1 \times 10^7$. En plus du signal de données Cseq, le générateur reçoit les signaux de synchronisation de multitrame, de trame et de séquence Cmfe, Cfe et Cse, de façon qu'il soit possible de produire des erreurs seulement dans les bits de trame ou les bits de multitrame, si on le désire. Il existe une sortie qui commande une entrée d'une porte OU-EXCLUSIF 328, dont l'autre entrée reçoit la configuration binaire produite non perturbée Cseq'; la porte 328 fournit donc le signal de séquence non perturbé Cseq".

Le générateur de parité 322 a pour fonction de produire un total de contrôle à 4 bits (par exemple) pendant chaque demi-multitrame, et d'insérer ensuite ces quatre bits aux positions prédéterminées appropriées dans la demi-multitrame suivante. Dans une liaison de télécommunication, un générateur similaire serait présent à l'extrémité réceptrice et les totaux de contrôle seraient comparés après extraction des bits appropriés. Pour commander cette forme connue de générateur de parité, la mémoire 30 est programmée en ce qui concerne les bits D5 et D6, de façon à produire des signaux de commande Cpe1 et Cpe2 qui indiquent respectivement des positions de bits à la fin de chaque demi-multitrame. Par exemple, pour une multitrame de longueur M (figure 5), qui est indiquée par une impulsion de remise à zéro 40 fournie par le bit de données de mémoire D0, les positions de bits de total de contrôle correspondantes pourraient être P1, P2, P3 et P4. Le bit D5 (Cpe1) est alors programmé de façon à produire une impulsion à chaque position de bit, et le bit D6 (Cpe2) est programmé pour indiquer le début de chaque séquence de positions de bit. En outre, le générateur 321 reçoit le signal de séquence binaire non perturbé Cseq, de façon à pouvoir former le total de contrôle. Le générateur de parité 321 fournit une impulsion sur sa sortie BAS chaque fois qu'un bit de parité à insérer est au niveau bas, et il fournit une impulsion sur sa sortie HAUT chaque fois qu'un bit de parité à insérer est au niveau haut. Les signaux des sorties HAUT et BAS sont combinés avec le signal de configuration binaire (Cseq') par la porte OU 330 et la porte ET 329, pour fournir le signal de configuration binaire Tx désiré (Cseq''').

On notera en outre que le mode de réalisation peut aisément être programmé sur la base de la longueur d'une composante particulière quelconque du train de données et de son contenu. Pour permettre la commande d'un générateur de séquences externe, des signaux Cmf (synchronisation de multitrame), Cf (synchronisation de trame), Ct (code de départ), Cp (code d'arrêt), P (code de parité), Mf (en-tête de multitrame), H (en-tête de trame) et Cseq (horloge de générateur de séquences) sont respectivement appliqués à des sorties particulières.

Bien qu'on puisse programmer le système en fixant des données dans un dispositif de mémoire morte (ROM) qui constitue le dispositif 30, et qu'on puisse reprogrammer le système en échangeant des mémoires mortes, la stabilité des données signifie que le bus d'adresse de mémoire 308 et le bus de données 309 sont libres pendant la période d'horloge. On peut donc utiliser une mémoire vive pour le dispositif de mémoire 30, et on peut programmer et reprogrammer ce dernier pendant les périodes d'horloge.

On utilise dans ce but un contrôleur qui est destiné à prendre en charge les bus de données 308 et 309 chaque fois qu'on désire effectuer une opération de reprogrammation. Le fonctionnement du contrôleur est synchronisé sur l'horloge de base par la ligne 311. Pour effectuer la reprogrammation, les données qui définissent la nouvelle norme à suivre sont tout d'abord assemblées dans une mémoire de contrôleur, sous la forme d'un tableau de données en fonction de l'adresse, c'est-à-dire sous une forme analogue aux tableaux de données indiqués ci-dessus à titre d'exemples. Lorsque des données à une adresse déterminée diffèrent de celle qui se trouve au moment présent dans la mémoire vive 30, les sorties du bus de données du contrôleur, 312, sont fixées à des valeurs correspondant à l'adresse à changer. Cette adresse est enregistrée dans un réseau de verrouillage d'adresse 313 sous l'effet d'un signal d'horloge (Ecriture adresses) que le contrôleur 310 applique à l'entrée d'horloge du réseau de verrouillage d'adresses. Les sorties du bus de données du contrôleur 312 sont maintenant fixées aux valeurs correspondant aux données exigées dans la mémoire vive 30, à l'adresse qui vient d'être verrouillée dans le réseau de verrouillage d'adresses 313. Ces données sont verrouillées de façon similaire dans le Réseau de Verrouillage de Données 314, par un signal "Ecriture données". Une fois que les données ont été verrouillées, le contrôleur 310 applique un signal Ecriture RAM à l'entrée WE (autorisation d'écriture) 315 de la mémoire vive 30. Sous l'effet de ce signal, les données qui se trouvent dans le réseau de verrouillage de données 314 sont chargées dans la mémoire vive 30, à l'adresse qui est verrouillée dans le réseau de verrouillage d'adresses 314. On note que n'importe quelles autres adresses auxquelles des données sont en désaccord avec la nouvelle norme exigée, peuvent être changées de façon similaire pour reprogrammer la mémoire vive 30 conformément à la nouvelle norme.

Pour achever la description du mode de réalisation présent, on notera que pendant le fonctionnement normal, le signal Ecriture RAM maintient les données de sortie d'horloge à l'état actif sur le bus d'adresse 308, par l'intermédiaire de son entrée d'autorisation 317, et invalide de façon similaire les données du Réseau de Verrouillage d'Adresses (313), par l'intermédiaire de l'inverseur 316. Les sorties du réseau de verrouillage de données 314 sont isolées de façon similaire du bus de données 309, de façon que la mémoire vive 30 puisse commander le bus. Inversement, pendant la reprogrammation, la mémoire 30 est invalidée sous l'effet du signal présent sur son entrée WE.

Le contrôleur 310 reçoit le signal d'horloge 311 pour faire en sorte que la reprogrammation ne se produise pas à l'instant d'une transition du compteur. Si on le désire, la reprogrammation peut être synchronisée sur la restauration de multitrame, en tenant compte du signal présent sur l'entrée 318 du contrôleur.

Le contrôleur 310 peut comprendre une interface d'utilisateur, qui est elle-même programmée de façon à collecter des instructions d'utilisateur et à fournir les signaux de commande nécessaires, comme décrit ci-dessus. Le contrôleur peut consister en un système à micro-ordinateur, et l'homme de l'art pourra réaliser aisément les fonctions de programmation et d'interface nécessaires pour ce système.

Il va de soi que de nombreuses modifications peuvent être apportées au dispositif décrit et représenté, sans sortir du cadre de l'invention.

## Revendications

1. Générateur de données numériques destiné à produire un train de données de sortie selon un format de trame conforme à une norme de télécommunication, caractérisé en ce qu'il comprend : un dispositif de mémoire (10; 30) destiné à enregistrer des mots de données (D0, D1, ... D4; D0, D1, ... D9), chaque bit de chaque mot de données représentant un état d'un signal parmi un ensemble de signaux de commande, pendant une trame; des moyens (12; 31) pour adresser le dispositif de mémoire de façon incrémentielle à partir d'une valeur prédéterminée, sous l'effet d'une horloge (14; 32); au moins un signal de commande étant représentatif d'une longueur de trame et étant appliqué aux moyens d'adressage pour commander le recommencement de l'adressage du dispositif de mémoire à partir de la valeur prédéterminée; un générateur de séquences (17; 324) destiné à produire un signal de données de séquence sous la dépendance d'au moins un signal de commande; et des moyens logiques pour combiner le signal de données de séquence avec au moins un signal de commande, pour fournir le train de données de sortie (Tx).

2. Générateur de données numériques selon la revendication 1, caractérisé en ce que les signaux de commande comprennent en outre des signaux représentatifs de la longueur de séquence, de la longueur de multitrame, de bits de synchronisation de trame et de bits de synchronisation de multitrame.

3. Générateur de données numériques selon l'une quelconque des revendications 1 ou 2, caractérisé en ce qu'il comprend en outre des moyens de verrouillage (100; 34) connectés au dispositif de mémoire (10; 30) et commandés par l'horloge (14; 32), pour verrouiller pendant chaque intervalle d'horloge les données qui sont lues dans le dispositif de mémoire.

4. Générateur de données numériques selon la revendication 3, caractérisé en ce qu'il comprend en outre des moyens de programmation (310, 313) destinés à écrire des données dans le dispositif de mémoire (30) pendant un intervalle d'horloge, pour permettre de changer ces mots de données afin de modifier les caractéristiques du train de données de sortie, tout en maintenant un fonctionnement continu du générateur.

5. Générateur de données numériques selon l'une quelconque des revendications 1 à 4, caractérisé en ce qu'il comprend en outre un générateur de perturbation (321) qui est destiné à injecter des erreurs dans le train de données de sortie.

6. Générateur de données numériques selon la revendication 5, caractérisé en ce que le générateur de perturbation (321) reçoit des signaux de commande représentatifs des synchronisations de trame et de séquence, ainsi que le signal de données de séquence, pour injecter des erreurs à des positions sélectionnées dans la trame et pour produire un train de données de sortie perturbé.

7. Générateur de données numériques selon l'une quelconque des revendications 1 à 6, caractérisé en ce qu'il comprend en outre un générateur de parité (322) qui reçoit le signal de données de séquence, pour produire des bits de parité à insérer dans le train de données de sortie.

7

8. Générateur de données numériques selon la revendication 7, caractérisé en ce que le dispositif de mémoire (30) enregistre des mots de données représentant les états de signaux de commande qui sont représentatifs des positions de bits auxquelles des bits de parité doivent être insérés dans le train de données de sortie, et qui sont appliqués au générateur de parité (322).

9. Générateur de données numériques selon l'une quelconque des revendications 1 à 8, caractérisé en ce qu'il comprend en outre un générateur d'alarme (320) destiné à insérer des bits d'alarme dans le train de données de sortie.

10. Générateur de données numériques selon la revendication 9, caractérisé en ce que le dispositif de mémoire (30) enregistre des mots de données représentant les états de signaux de commande qui sont représentatifs des positions de bit auxquelles des bits d'alarme doivent être insérés dans le train de données de sortie, et de la valeur des bits d'alarme, et qui sont appliqués au générateur d'alarme (320).

## Patentansprüche

1. Digitaldatengenerator für die Erzeugung einer Ausgangsdatenfolge nach einem Rasterformat gemäß einer Telekommunikationsnorm, dadurch gekennzeichnet, daß er die folgenden Bestandteile umfaßt: eine Speichereinrichtung (10; 30) für die Aufzeichnung der Datenwörtern(D0, D1, ... D4; D0, D1, ... D9), wobei jedes Bit von einzelnen Datenwörter einen Zustand eines Signals aus einer Gesamtheit von Steuersignalen während eines Rasters repräsentiert; Elemente (12; 31) zur inkrementellen Adressierung der Speichereinrichtung von einem vorgegebenen Wert aus unter der Einwirkung eines Taktgebers (14; 32), wobei mindestens ein Steuersignal eine Rasterlänge repräsentiert und auf die Adressierelemente angewendet wird, um den Neubeginn der Adressierung der Speichereinrichtung von einem vorgegebenen Wert aus zu steuern; einen Sequenzgenerator (17; 324) für die Erzeugung eines Sequenzdatensignals in Abhängigkeit von mindestens einem Steuersignal; und ferner logische Elemente für die Verbindung des Sequenzdatensignals mit mindestens einem Steuersignal, um die Ausgangsdatenfolge (Tx) bereitzustellen.

2. Digitaldatengenerator nach Anspruch 1, dadurch gekennzeichnet, daß die Steuersignale außerdem Signale umfassen, die repräsentativ für die Sequenzlänge, die Mehrfachrasterlänge, Raster-Synchronisationsbits und Mehrfachraster-Synchronisationsbits sind.

3. Digitaldatengenerator nach einem der Ansprüche 1 oder 2, dadurch gekennzeichnet, daß er außerdem mit der Speichereinrichtung (10; 30) verbundene und durch den Taktgeber (14; 32) gesteuerte Sperrelemente (100; 34) umfaßt, um während jedes Taktgeberintervalls die aus der Speichereinrichtung ausgelesenen Daten zu sperren.

4. Digitaldatengenerator nach Anspruch 3, dadurch gekennzeichnet, daß er außerdem Programmierelemente (310, 313) umfaßt, die dazu bestimmt sind, während eines Taktgeberintervalls Daten in die Speichereinrichtung (30) zu schreiben, damit diese Datenwörter gewechselt werden können, um die Merkmale der Ausgangsdatenfolge zu modifizieren und gleichzeitig einen durchgehenden Betrieb des Generators zu ermöglichen.

5. Digitaldatengenerator nach einem der Ansprüche 1 bis 4, dadurch gekennzeichnet, daß er außerdem einen Störgenerator (321) umfaßt, der dazu dient, Fehler in die Ausgangsdatenfolge einzufügen.

6. Digitaldatengenerator nach Anspruch 5, dadurch gekennzeichnet, daß der Störgenerator (321) Steuersignale, die repräsentativ für die Raster- und Sequenzsynchronisationen sind, sowie das Sequenzdatensignal empfängt, um Fehler an ausgewählten Positionen im Raster einzufügen und um eine gestörte Ausgangsdatenfolge zu erzeugen.

7. Digitaldatengenerator nach einem der Ansprüche 1 bis 6, dadurch gekennzeichnet, daß er außerdem einen Paritätsgenerator (322) umfaßt, der das Sequenzdatensignal empfängt, um Paritätsbits zu erzeugen, die in die Ausgangsdatenfolge einzufügen sind.

8. Digitaldatengenerator nach Anspruch 7, dadurch gekennzeichnet, daß die Speichereinrichtung (30) Datenwörter aufzeichnet, welche die Steuersignalzustände darstellen, die repräsentativ für die Bitpositionen sind, an denen Paritätsbits in der Ausgangsdatenfolge eingefügt werden sollen, und die auf den Paritätsgenerator (322) angewendet werden.

9. Digitaldatengenerator nach einem der Ansprüche 1 bis 8, dadurch gekennzeichnet, daß er außerdem einen Alarmgenerator (320) umfaßt, der dazu dient, Alarmbits in die Ausgangsdatenfolge einzufügen.

10. Digitaldatengenerator nach Anspruch 9, dadurch gekennzeichnet, daß die Speichereinrichtung (30) Datenwörter aufzeichnet, welche die Steuersignalzustände darstellen, die repräsentativ für die Bitpositionen, an denen Alarmbits in der Ausgangsdatenfolge eingefügt werden sollen, sowie für den Wert der Alarmbits sind und die auf den Alarmgenerator (320) angewendet werden.

## Claims

1. Digital data generator intended for producing an output data stream in accordance with a frame format in conformity with a telecommunications standard, characterized in that it comprises a memory device (10; 30) for recording data words (D0, D1,... D4; D0, D1,... D9), each bit of each data word representing one state of a signal among a plurality of control signals, during a frame ; means (12; 31) for addressing the memory device incrementally from a predetermined value in response to a clock (14; 32); at least one control signal being representative of a frame length and being applied to the addressing means in order to cause addressing of the memory device to recommence from the predetermined value; a sequence generator (17; 324) for producing a sequence data signal in response to at least one control signal; and logic means for combining the sequence data signal with at least one control signal to provide the output data stream (Tx).

2. Digital data generator according to claim 1, characterized in that the control signals further include signals representative of sequence length, of multiframe length, of frame synchronization bits, and of multiframe synchronization bits.

3. Digital data generator according to any one of claims 1 or 2, characterized in that it further includes latch means (100; 34) connected to the memory device (10; 30) and controlled by the clock (14; 32) for latching the data read from the memory device during each clock interval.

4. Digital data generator according to claim 3, characterized in that it further includes programming means (310, 313) for writing data into the memory device (30) during a clock interval, thereby enabling said data words to be changed in order to modify the characteristics of the output data stream while maintaining continuous operation of the generator.

5. Digital data generator according to any one of claims 1 to 4, characterized in that it further includes a disturbance generator (321) for injecting errors into the output data stream.

6. Digital data generator according to claim 5, characterized in that the disturbance generator (321) receives control signals respresentative of frame and sequence synchronizations, together with the sequence data signal, to inject errors at selected positions in the frame and to produce a disturbed output data stream.

7. Digital data generator according to any one of claims 1 to 6, characterized in that it further includes a parity generator (322) which receives the sequence data signal for generating parity bits to be inserted in the output data stream.

8. Digital data generator according to claim 7, characterized in that the memory device (30) stores data words representative of the states of control signals representative of the bit positions at which parity bits are to be inserted into the output data stream, and which are applied to the parity generator (322).

9. Digital data generator according to any one of claims 1 to 8, characterized in that it further includes an alarm generator (320) for inserting alarm bits in the output data stream.

10. Digital data generator according to claim 9, characterized in that the memory device (30) stores data words representative of the states of control signals which are representative of the bit positions in which alarm bits are to be inserted in the output data stream, and of the values of the alarm bits, and which are applied to the alarm generator (320).

FIG.1

FIG.2

FIG.3

EP 0 397 559 B1

EP 0 397 559 B1

Position
dans la trame    7 0 1 2 3 4 5 6 7 0 1 2 3 4 5 6 7 0 1 2 3 4 5 6 7 0 1 2 3 4 5. 6 7

Coe1

Sortie du
générateur   Haut
d'alarme

Sortie du
générateur   Bas
d'alarme

## FIG.4

## FIG.5

M

DO                                                                    40

P1   P2   P3   P4   P1   P2   P3   P4   P1   P2   P3   P4   P1

Cpe1

Cpe2